# EUROPEAN PATENT APPLICATION

(11) **EP 3 324 272 A2**
(43) Date of publication of application: **23.05.2018**
(21) Application number: 17201965.5
(22) Date of filing: 15.11.2017
(51) Int. Cl.: G06F 3/01, G06F 1/16

(54) **CONTROL OF CONTACT CONDITIONS FOR STATIC ESF**

(30) Priority: 17.11.2016 US 201615354148
(71) Applicant: Immersion Corporation, San Jose, CA 95134 (US)
(72) Inventor: LEVESQUE, Vincent, Montreal, Québec H2W 2R2 (CA); ALGHOONEH, Mansoor, Montreal, Québec H2W 2R2 (CA); SABOUNE, Jamal, Montreal, Québec H2W 2R2 (CA); KHOSHKAVA, Vahid, Montreal, Québec H2W 2R2 (CA); MOTAMEDI, Mohammadreza, Montreal, Québec H2W 2R2 (CA); GRANT, Danny A., Montreal, Québec H2W 2R2 (CA); CRUZ-HERNANDEZ, Juan Manuel, Montreal, Québec H2W 2R2 (CA); WU, Liwen, Montreal, Québec H2W 2R2 (CA)
(74) Representative: Richardson, Mark Jonathan

(57) **Abstract**

Examples of devices (100, 200, 300, 400, 500, 600, 700, 800, 900, 1000, 1100, 1200, 1300, 1400, 1500), systems, and methods of controlling one or more contact conditions of an insulated static electrostatic force electrode (105, 205, 305, 310, 315, 320, 325, 330, 335, 405, 505, 605, 735, 805, 905, 1005, 1105, 1205, 1305, 1405, 1505) are disclosed. One example device has an insulated static electrostatic force electrode and a flexible suspension (110, 210, 215, 220, 340, 345, 350, 355, 360, 365, 370, 410, 510, 515, 520, 610, 615, 10, 715, 720, 725, 730, 810, 1415) attached to insulated the static electrostatic force electrode. In examples, the flexible suspension controls a contact condition of the static electrostatic force electrode to alter the static electrostatic force feedback provided by the insulated static electrostatic force electrode.

## Description

### FIELD

The present application generally relates to haptic devices and more generally relates to the control of contact conditions for static electrostatic force electrodes.

### BACKGROUND

Traditionally, mechanical buttons have provided physical tactile sensations to users of electronic devices. However, as the size of electronic devices has decreased and the portability of electronic devices has increased, the number of mechanical buttons on electronic devices has decreased and some electronic devices do not have any mechanical buttons. Haptic output devices may be included in such devices to output haptic effects to users. However, there is a need to increase the strength of haptic feedback provided by static electrostatic force devices and a need to provide haptic feedback by controlling contact conditions of static electrostatic force electrodes.

### SUMMARY

Various examples are described for devices, systems, and methods to control contact conditions for static electrostatic force ("SESF") electrodes. One example of an SESF is electrostatic friction and one example of an SESF electrode is an electrostatic force electrode, such as an electrostatic friction electrode.

One example disclosed static electrostatic force output device includes: an insulated static electrostatic force electrode configured to provide static electrostatic force feedback to a user and comprising a first surface configured to face toward the user's skin and a second surface opposite the first surface; and a flexible suspension attached to the second surface of the insulated static electrostatic force electrode and configured to at least partially move in relation to the insulated static electrostatic force electrode to control a contact condition corresponding to the insulated static electrostatic force electrode.
The static electrostatic force output device may be modified in any suitable way disclosed herein including, but not limited to, any one or more of the following. The static electrostatic force output device may be configured such that the flexible suspension comprises a layer of rubber attached to the second surface of the insulated static electrostatic force electrode. The static electrostatic force output device may be configured such that the flexible suspension comprises a layer of foam attached to the second surface of the insulated static electrostatic force electrode. The static electrostatic force output device may be configured such that the flexible suspension comprises a smart material attached to the second surface of the insulated static electrostatic force electrode, and wherein the insulated static electrostatic force electrode is a rigid static electrostatic force electrode. The static electrostatic force output device may be configured such that the flexible suspension comprises a smart material attached to the second surface of the insulated static electrostatic force electrode and a plurality of flexible posts attached to the smart material, and wherein the insulated static electrostatic force electrode is a flexible static electrostatic force electrode. The static electrostatic force output device may be configured such that the insulated static electrostatic force electrode comprises a static electrostatic force electrode array. The static electrostatic force output device may be configured such that the insulated static electrostatic force electrode comprises a plurality of static electrostatic force electrodes and the flexible suspension comprises a plurality of springs corresponding to the first plurality of static electrostatic force electrodes. The static electrostatic force output device may be configured such that the insulated static electrostatic force output device does not comprise an actuator that controls the contact condition corresponding to the insulated static electrostatic force electrode. The static electrostatic force output device may be configured such that the insulated static electrostatic force output device does not comprise a sensor that measures the contact condition corresponding to the insulated static electrostatic force electrode. The static electrostatic force output device may further comprise: a flexible band attached to the insulated static electrostatic force electrode; and, a motor attached to the flexible band, the motor configured to control a tightness of the flexible band. The static electrostatic force output device may be configured such that the flexible suspension comprises a flexible flap that extends from a part of the insulated static electrostatic force output device worn by the user, and wherein the insulated static electrostatic force electrode is attached to the flexible flap. The static electrostatic force output device may be configured such that the flexible suspension comprises a band and the insulated static electrostatic force electrode is cantilevered with respect to the band. The static electrostatic force output device may be configured such that the insulated static electrostatic force electrode comprises a plurality of curls. The static electrostatic force output device may be configured such that the insulated static electrostatic force electrode comprises at least one of a first plurality of spacers or a second plurality of grooves. The static electrostatic force output device may be configured such that the insulated static electrostatic force electrode comprises a curved shape conforming to the user's wrist. The static electrostatic force output device may be configured such that the flexible suspension comprises a smart material and the device further comprises an actuator integrated into or attached to the smart material. The static electrostatic force output device may be configured such that the device is a smartwatch.

One example disclosed method includes: measuring, by a sensor, a contact condition corresponding to an insulated static electrostatic force electrode; determining, by a processor, a change to the contact condition to improve static electrostatic force feedback provided by the insulated static electrostatic force electrode to a user; generating, by the processor, an actuator signal configured to cause an actuator to implement the change; and outputting the actuator signal to the actuator to implement the determined change.
The method may be modified in any suitable way disclosed herein including, but not limited to, any one or more of the following. The method may be configured such that the sensor comprises at least one of a proximity sensor, a pressure sensitive surface sensor, or a contact sensitive surface sensor. The method may be configured such that the actuator comprises a smart material and the actuator implements the change by altering the smart material to move the insulated static electrostatic force electrode. The method may be configured such that the contact condition comprises at least one of a distance between the user's skin and the insulated static electrostatic force electrode, an amount of pressure between the user's skin and the insulated static electrostatic force electrode, or a pressure distribution between the user's skin and the static electrostatic force electrode. The method may be configured such that the change is configured to cause the insulated static electrostatic force electrode to provide consistent static electrostatic force feedback to the user. The method may be configured such that the change is configured to cause the insulated static electrostatic force electrode to provide increased static electrostatic force feedback to the user. The method may be configured such that the actuator signal is configured to cause the actuator to tilt the insulated static electrostatic force electrode. There is further provided a non-transitory computer-readable medium including one or more software applications configured to be executed by a processor to give effect the method as described above.

One example disclosed non-transitory computer-readable medium includes one or more software applications configured to be executed by a processor. In this example, the one or more software applications is configured to: receive a contact condition corresponding to an insulated static electrostatic force electrode from a sensor; determine a change to the contact condition to improve static electrostatic force provided by the insulated static electrostatic force electrode to a user; generate an actuator signal configured to cause an actuator to implement the change; and output the actuator signal to the actuator to implement the determined change.
The non-transitory computer-readable medium may be modified in any suitable way disclosed herein including, but not limited to, any one or more of the following. The non-transitory computer-readable medium may be configured such that the sensor comprises at least one of a proximity sensor, a pressure sensitive surface sensor, or a contact sensitive surface sensor. The non-transitory computer-readable medium may be configured such that the actuator comprises a smart material and the actuator implements the change by altering the smart material to move the insulated static electrostatic force electrode. The non-transitory computer-readable medium may be configured such that the contact condition comprises at least one of a distance between the user's skin and the insulated static electrostatic force electrode, an amount of pressure between the user's skin and the insulated static electrostatic force electrode, or a pressure distribution between the user's skin and the insulated static electrostatic force electrode. The non-transitory computer-readable medium may be configured such that the change is configured to cause the insulated static electrostatic force electrode to provide consistent static electrostatic force feedback to the user. The non-transitory computer-readable medium may be configured such that the change is configured to cause the insulated static electrostatic force electrode to provide increased static electrostatic force feedback to the user. The non-transitory computer-readable medium may be configured such that the actuator signal is configured to cause the actuator to tilt the insulated static electrostatic force electrode.

These illustrative examples are mentioned not to limit or define the scope of this disclosure, but rather to provide examples to aid understanding thereof. Illustrative examples are discussed in the Detailed Description, which provides further description. Advantages offered by various examples may be further understood by examining this specification.

### BRIEF DESCRIPTION OF THE DRAWINGS

The accompanying drawings, which are incorporated into and constitute a part of this specification, illustrate one or more certain examples and, together with the description of the example, serve to explain the principles and implementations of the certain examples.
Figure 1 shows an example SESF device having a flexible suspension to passively control a contact condition of an SESF electrode according to an embodiment.
Figure 2A and 2B show an example SESF device having a flexible suspension to passively control a contact condition of an SESF electrode according to an embodiment.
Figure 3 shows an example SESF device having a flexible suspension to passively control a contact condition of an SESF electrode according to an embodiment.
Figure 4 shows an example SESF device having a flexible suspension and an actuator to actively control a contact condition of an SESF electrode according to an embodiment.
Figure 5 shows an example SESF device having a flexible SESF electrode to passively control a contact condition of the SESF electrode according to an embodiment.
Figure 6 shows an example SESF device having a flexible SESF electrode to passively control a contact condition of the SESF electrode according to an embodiment.
Figure 7 shows an example SESF device having a flexible SESF electrode to passively control a contact condition of the SESF electrode according to an embodiment.
Figure 8 shows an example SESF device having a flexible SESF electrode and an actuator to actively control a contact condition of the SESF electrode according to an embodiment.
Figure 9 shows an example SESF device having an SESF electrode shaped to passively control a contact condition of the SESF electrode according to an embodiment.
Figure 10 shows an example SESF device having an SESF electrode shaped to passively control a contact condition of the SESF electrode according to an embodiment.
Figure 11 shows an example SESF device having an SESF electrode with spacers to passively control a contact condition of the SESF electrode according to an embodiment.
Figure 12 shows an example SESF device having SESF electrodes with grooves to passively control a contact condition of the SESF electrodes according to an embodiment.
Figure 13 shows an example SESF device having an SESF electrode attached to actuated smart material spaces to actively control a contact condition of the SESF electrode according to an embodiment.
Figure 14 shows an example SESF device having a cantilevered SESF electrode to passively control a contact condition of the SESF electrode according to an embodiment.
Figure 15 shows an example SESF device having a cantilevered SESF electrode to actively control a contact condition of the SESF electrode according to an embodiment.
Figure 16 shows an example method of actively controlling a contact condition of an SESF electrode according to an embodiment.
Figure 17 shows an example SESF device having a flexible SESF electrode, an actuator, a sensor, and a processor to actively control a contact condition of the SESF electrode according to an embodiment.

### DETAILED DESCRIPTION

Examples are described herein in the context of devices, systems, and methods to control contact conditions for SESF. Those of ordinary skill in the art will realize that the following description is illustrative only and is not intended to be in any way limiting. Reference will now be made in detail to implementations of examples as illustrated in the accompanying drawings. The same reference indicators will be used throughout the drawings and the following description to refer to the same or like items.

In the interest of clarity, not all of the routine features of the examples described herein are shown and described. It will, of course, be appreciated that in the development of any such actual implementation, numerous implementation-specific decisions must be made in order to achieve the developer's specific goals, such as compliance with application- and business-related constraints, and that these specific goals will vary from one implementation to another and from one developer to another.

### Illustrative Example of Controlling a Contact Condition for Static Electrostatic Force

In one example, a user wears a smartwatch on his or her wrist. As the user moves around (e.g., walking, running, etc.), the smartwatch moves along the user's wrist, such by sliding up or down the user's wrist, or by rotation around the user's wrist. The smartwatch includes components that can provide SESF feedback to the user. To provide consistent SESF feedback to the user, the smartwatch includes a suspension mechanism to maintain a fixed or relatively fixed distance between an insulated SESF electrode in the smartwatch and the skin on the user's wrist. Accordingly, even though the smartwatch moves along the user's wrist, consistent SESF feedback is provided to the user by controlling a distance contact condition between the insulated SESF electrode in the smartwatch and a user's skin.

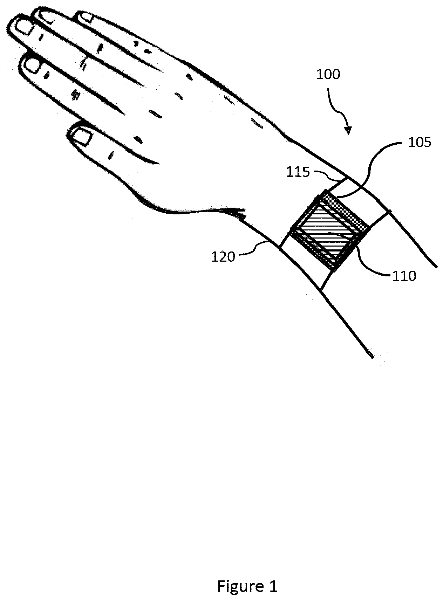

Referring now to Figure 1, this figure shows a smartwatch 100 having an example SESF device. The SESF device has a flexible suspension 110 and an insulated rigid SESF electrode 105. For example, the SESF electrode 105 may be an insulated rigid electrostatic friction electrode. The flexible suspension 110 passively controls a contact condition of the insulated rigid SESF electrode 105 according to an embodiment. The smartwatch 100 shown in Figure 1 also has a band 115 that a user can wrap around his or her arm or wrist 120. The SESF electrode 105 has a first surface that faces towards the user's wrist 120 and a second surface that faces opposite the user's wrist 120 and towards flexible suspension 110 and a watch face (not shown). In this example, the flexible suspension 110 has a flexible surface - such as a layer of rubber, a layer of foam, or another suitable material - that is directly or indirectly attached to the second surface of the insulated rigid SESF electrode 105 to control a contact condition corresponding to the insulated rigid SESF electrode 105. For example, the flexible surface may allow the flexible suspension to deform in response to pressure. In this example, the pressure applied to the insulated rigid SESF electrode 105 causes the insulated rigid SESF electrode 105 to move. In response, the flexible suspension 110 deforms to control a pressure contact condition, such as an amount of pressure the insulated rigid SESF electrode 105 applies to a user's skin. Thus, as shown in Figure 1, the insulated rigid SESF electrode 105 can be mounted on the flexible suspension 110 of the smartwatch 100 such that the flexible suspension controls an amount of pressure applied to the insulated rigid SESF electrode 105.

This illustrative example is not intended to be in any way limiting, but instead is intended to provide an introduction to the subject matter of the present application. Other examples of externally-activated haptic devices are described below.

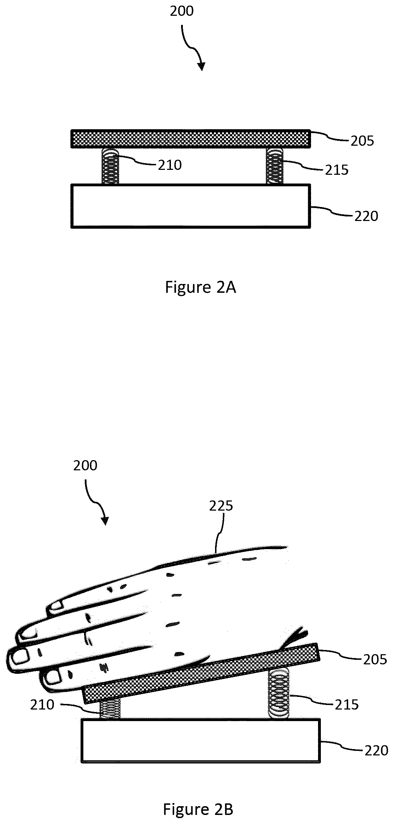

Referring now to Figures 2A and 2B, these figures show an example SESF device having a flexible suspension to passively control a contact condition of an SESF electrode according to an embodiment. As shown in Figure 2A, an SESF device 200 includes an SESF electrode 205 mounted on a flexible suspension (collectively, 210, 215, 220). The SESF electrode 205 can be an electrostatic friction electrode.

In this example, the flexible suspension has springs 210 and 215 mounted on rigid surface 220. Thus, in embodiments, a flexible suspension includes a mechanical suspension such as one or more springs. In some embodiments, the flexible suspension is one or more springs and/or other material(s) that present similar properties as a spring, such as compression and/or extension. In Figures 2A and 2B, the flexible suspension has a rigid base 220 attached to a mechanical suspension. In other embodiments, a flexible suspension includes a semi-rigid base. In embodiments, SESF electrode 205 is an insulated SESF electrode.

When a user's hand 225 contacts the SESF electrode 205 as shown in Figure 2B, the springs 210, 215 respond to the contact. For example, in Figure B spring 210 compresses, spring 215 decompresses, and the SESF electrode 205 tilts in order to adapt to improve the uniformity of the pressure between the SESF electrode 205 and the user's hand 225. In embodiments, any number of body parts may be in contact with the SESF electrode 205 including, but not limited to, a user's finger or fingers, a user's hand or hands, a user's wrist, a user's arm, a user's ankle, etc. In embodiments, a mechanical suspension improves the uniformity of a pressure between an SESF electrode and a user by allowing the electrode to tilt in order to adapt to uneven pressure distribution. In embodiments, an SESF device has an SESF electrode attached to a flexible suspension that controls an amount of pressure applied or a distribution of the pressure applied, or both.

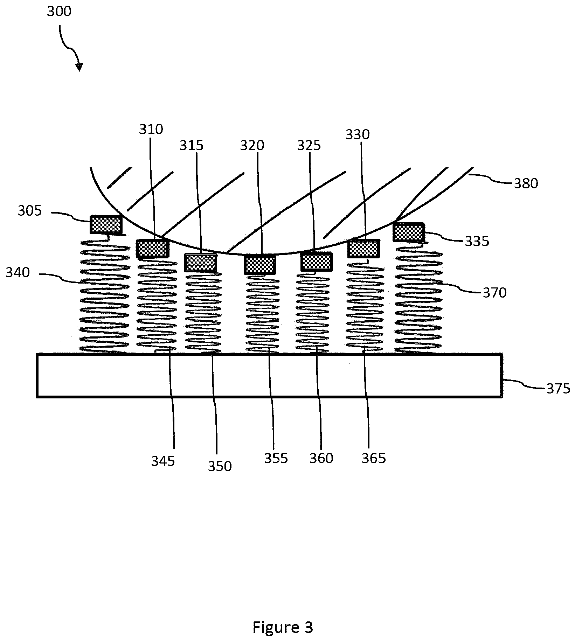

Referring now to Figure 3, this figure shows an example SESF device having a flexible suspension to passively control a contact condition of an SESF electrode according to an embodiment. As shown in Figure 3, an SESF device 300 includes a plurality of miniature SESF electrodes (305, 310, 315, 320, 325, 330, 335), a flexible suspension comprising a plurality of mechanical suspensions (e.g., springs 340, 345, 350, 355, 360, 365, 370), mount to rigid surface 375. One or more of the miniature SESF electrodes (305, 310, 315, 320, 325, 330, 335) can be an electrostatic friction electrode. In this example, each SESF electrode is mounted to a corresponding mechanical suspension. For example, in Figure 3, SESF electrode 305 is mounted to spring 340, SESF electrode 310 is mounted to spring 345, SESF electrode 315 is mounted to spring 350, SESF electrode 320 is mounted to spring 355, SESF electrode 325 is mounted to spring 360, SESF electrode 330 is mounted to spring 365, and SESF electrode 335 is mounted to spring 370.

In this example, each mechanical suspension is mounted to rigid surface 375. As a user's skin 380 contacts one or more miniature SESF electrodes (305, 310, 315, 320, 325, 330, 335), respective spring(s) (340, 345, 350, 355, 360, 365, 370) compress or decompress depending on the pressure applied. In this way, an array of miniature SESF electrodes can be used such that pressure control can be applied locally on different patches of skin. As shown in Fig 3, a plurality of SESF electrodes (305, 310, 315, 320, 325, 330, 335) can be mounted to respective mechanical suspensions, such as springs (340, 345, 350, 355, 360, 365, 370), in an SESF device 300 to control an amount of pressure applied or a distribution of the pressure applied, or both, for each SESF electrode. In embodiments, rigid SESF electrode 405 is an insulated rigid SESF electrode.

In some examples, one or more of the miniature SESF electrodes can be activated in a specific order. For example, miniature SESF electrode 305 may be activated, followed by the activation of miniature SESF electrode 310, followed by the activation of miniature SESF electrode 315, followed by the activation of miniature SESF electrode 320, etc. to create a moving effect. As another example, miniature SESF electrodes 305, 310 may be activated, followed by the activation of miniature SESF electrodes 315,320, followed by the activation of miniature SESF electrodes 325, 330, etc. to create a moving effect. In some embodiments, some of the miniature SESF electrodes can be activated simultaneously followed by the activation of other miniature SESF electrodes to create a patterned effected. In one embodiment, all of the miniature SESF electrodes (305, 310, 315, 320, 325, 330, 330) are activated simultaneously.

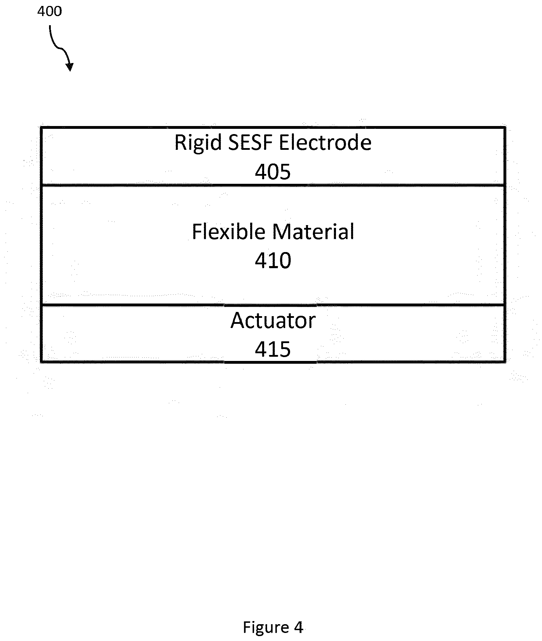

Referring now to Figure 4, this figure shows an example SESF device having a flexible suspension and an actuator to actively control a contact condition of an SESF electrode according to an embodiment. In this example, SESF device 400 includes a rigid SESF electrode 405 attached to a flexible material 410 and an actuator 415 attached to the flexible material 410. Rigid SESF electrode 405 may be a rigid electrostatic friction electrode. In this example, SESF device 400 uses actuator 415 to alter flexible material 410 to change an amount of pressure applied to at least part of the rigid SESF electrode 405. For example, actuation 415 can alter a property of flexible material 410 - such as by changing a stiffness, a size, etc. of flexible material 410 - to change an amount of pressure applied to at least part of the rigid SESF electrode 405.

In embodiments, flexible material 410 is a smart material such as a magneto-rheological fluid, an electro-rheological fluid, a shape memory polymer, smart gel, or shape memory alloy. In embodiments, actuator 415 is a smart gel, an electromagnetic actuator, a DC motor, a pneumatic actuator, or a shape memory actuation (SMA) actuator. In embodiments, a contact condition of rigid SESF electrode 405 is controlled by altering a magnetic field corresponding to flexible material 410. In embodiments, a contact condition of rigid SESF electrode 405 is controlled by altering an electric field corresponding to flexible material 410.

In Figure 4, actuator 415 is attached to flexible material 410. In other embodiments, actuator 415 is integrated into flexible material 410. In Figure 4, a single SESF electrode 405, a single flexible material 410, and a single actuator 415 are shown. In other embodiments, an SESF device includes one or more SESF electrodes, one or more flexible materials, and one or more actuators. For example, an SESF device may have an SESF electrode array and a DC electromagnetic actuator array, such as a plurality of miniaturized linear solenoid actuators. In this example, a distance contact condition can be controlled using one or more actuators in the DC electromagnetic actuator array.

In one embodiment, an SESF device has a smart gel, such as Hydrogel, attached to a rigid SESF electrode. In this embodiment, a stimulus - such as an electrical voltage, a current, and/or light - is applied to the smart gel. When the stimulus is applied, the smart gel changes shape and thus can be used to control a contact condition corresponding to the rigid SESF electrode to which it is attached.

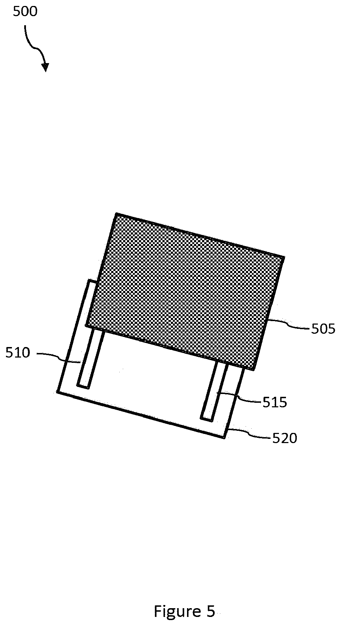

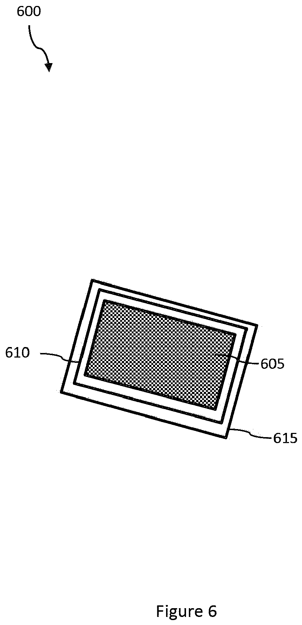

Referring now to Figures 5 and 6, these figures show example SESF devices having a flexible SESF electrode to control a contact condition of an SESF electrode according to embodiments. As shown in these figures, SESF devices (500, 600) comprise a flexible SESF electrode (505, 605) attached to a flexible frame (e.g., collectively, 510, 515, 520 in Figure 5 and collectively, 610, 615 in Figure 6). For example, in Figure 5, the flexible frame (e.g., collectively, 510, 515, 520) includes a plurality of flexible posts (e.g., 510, 515) which are attached to a rigid base 520. In Figure 6, the flexible frame (e.g., collectively, 610, 615) includes a flexible layer 610 attached to a rigid base 615. In these examples, the flexible SESF electrode (505, 605) is attached to the flexible frame such that the flexible SESF electrode (505, 605) bends under a user's touch to conform to the user's body part (e.g., a user's finger, a user's wrist, etc.) touching the flexible SESF electrode (505, 605). In embodiments, SESF electrodes 505, 605 are insulated, flexible electrostatic friction electrodes.

In some embodiments, a flexible SESF electrode is attached to a flexible frame that has any number of posts such as a single post, two posts, three, posts, four posts, five posts, etc. In some embodiments, a flexible SESF electrode is attached to a flexible frame having any number of flexible layers such as a single flexible layer, two flexible layers, three flexible layers, etc.

In some embodiments, a flexible SESF electrode controls an amount of applied pressure contact condition. In some embodiments, a flexible SESF electrode controls a pressure distribution contact condition. In yet other embodiments, a flexible SESF electrode controls at least two contact conditions, such as an amount of pressure applied and a pressure distribution.

In embodiments, an SESF electrode is insulated. For example, a flexible or rigid SESF electrode can include a thin metal sheet covered with Kapton tape. In an embodiment, an insulated SESF electrode includes a conductive surface, such as a conductive rubber and/or a conductive gel, covered with an insulation layer. In embodiments, an insulated SESF electrode is stretchable. In this example, the insulated flexible SESF electrode may be attached to a rigid frame. In other embodiments, an insulated SESF electrode is rigid.

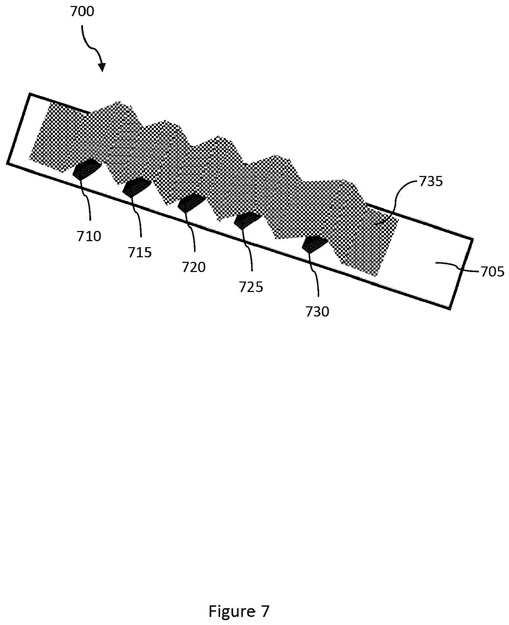

Referring now to Figure 7, this figure shows an example SESF device having a flexible SESF electrode to passively control a contact condition of an SESF electrode. As shown in Figure 7, SESF device 700 includes a plurality of flexible structures (710, 715, 720, 725, 730) extending from surface 705. In this example, a plurality of curls, or loops, are formed in flexible SESF electrode 735 by attaching the flexible SESF electrode 735 over the plurality of flexible structures (710, 715, 720, 725, 730). In this example, the curls act as springs to control a pressure distribution around a user's wrist. In embodiments, the flexible SESF electrode 735 is an insulated flexible SESF electrode. SESF electrode 735 may be a flexible electrostatic friction electrode.

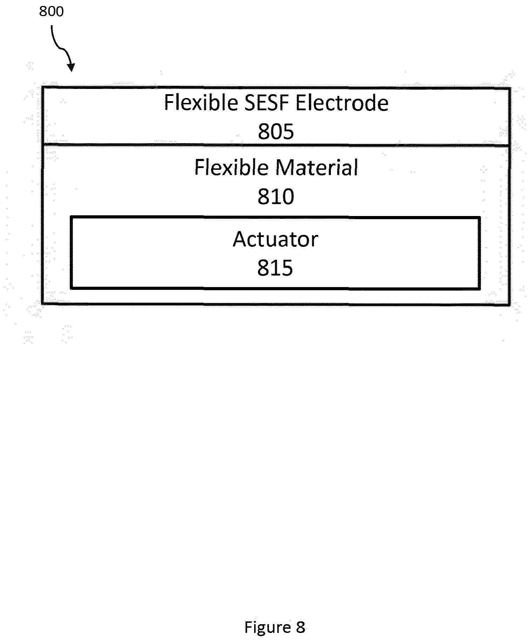

Referring now to Figure 8, this figure shows an example SESF device having a flexible SESF electrode and an actuator to actively control a contact condition of the SESF electrode according to an embodiment. In this example, SESF device 800 includes a flexible SESF electrode 805 attached to a flexible material 810. In embodiments, flexible SESF electrode 805 is an insulated flexible electrostatic friction electrode. In Figure 8, flexible material 810 includes actuator 815; however, in other embodiments, flexible material 810 is attached to an actuator. Example flexible materials and example actuators are discussed herein, such as in Figure 4 above with respect to flexible material 410 and actuator 415. In the example shown in Figure 8, changes to the flexible material 810 cause a contact condition of the flexible SESF electrode 805 to be controlled. For example, a flexibility of flexible SESF electrode 805 can be altered to control an amount of pressure applied or a pressure distribution, or both. In one embodiment, flexible material 810 includes a smart material that is applied to the back of flexible SESF electrode 805 to control a flexibility of flexible SESF electrode 805. In one embodiment, flexible SESF electrode 805 includes the flexible material 810.

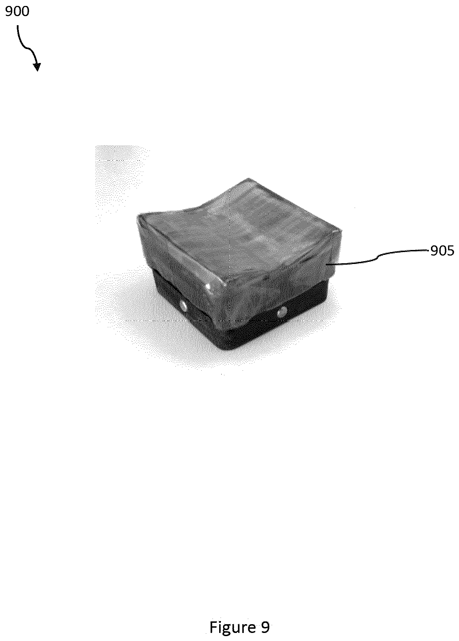

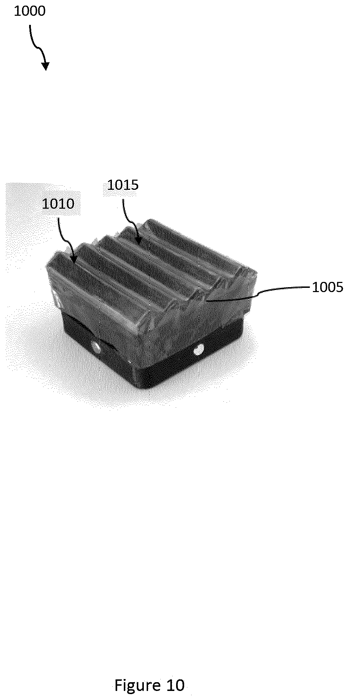

Referring now to Figures 9 and 10, these figures show example SESF devices having an SESF electrode shaped to passively control a contact condition of the SESF electrode according to an embodiment. In Figure 9, an SESF device 900 includes an SESF electrode 905 that is shaped to match a curvature of a user's wrist. The SESF electrode 905 can be an insulated SESF electrode and may be an electrostatic friction electrode. In some embodiments, SESF electrode 905 is shaped based on an average user of SESF device 900. In other embodiments, SESF electrode 905 shaped for a specific user. In this example, molding or 3D scanning may be used to design an SESF electrode that is shaped and customized for a specific user. In other examples, a memory foam or other suitable material can be used to capture and hold a customized shape of a user's body part to design an SESF electrode that is shaped and customized for a specific user. In Figure 9, SESF electrode 905 is contoured to match a curvature of an average user's wrist. In other embodiments, SESF electrode 905 is contoured to match a curvature of any number of body parts including, but not limited to, a user's wrist, a user's palm, a user's finger, a user's arm, or a user's ankle. In various embodiments, a shape of an SESF electrode controls a spacing against a user's skin or a pressure distribution against a user's skin, or both.

In the example shown in Figure 10, SESF device 1000 includes an SESF electrode 1005 that has a sinusoidal shape. In embodiments, the SESF electrode 1005 is an insulated SESF electrode and is an electrostatic friction electrode. In example shown in Figure 10, the sinusoidal shape of SESF electrode 1005 creates alternating conditions between contact sections (such as contact section 1010) and gap sections (such as gap section 1015). In some embodiments, a shape of an SESF electrode can alternate between different configurations. For example, an SESF electrode can alternate between a shallow configuration or a deep configuration. In some examples where the SESF electrode is a sinusoidal SESF electrode, a depth of the sinusoidal SESF electrode can be altered between a shallow sinusoidal configuration and a deep sinusoidal configuration such as by applying an electrical voltage and/or heat.

In other embodiments, a shape of an SESF electrode is actively altered to adapt to a shape of a user's body part. For example, a curvature of an SESF electrode can be altered using one or more actuators to increase pressure distribution uniformity. As another example, a depth of a sinusoidal SESF electrode may be actively altered to control a distance to a user's skin. In one embodiment, an SESF electrode includes a shape memory polymer sheet coated with at least one conductive material and an electrical voltage is applied to deform at least part of the polymer sheet to change a shape of the SESF electrode to improve SESF feedback provided by the SESF electrode. In another embodiment, an SESF electrode includes a shape memory polymer sheet coated with at least one conductive material and heat, such as heat from a user's skin or another heat source, is applied to deform at least part of the polymer sheet to change a shape of the SESF electrode to improve SESF feedback provided by the SESF electrode.

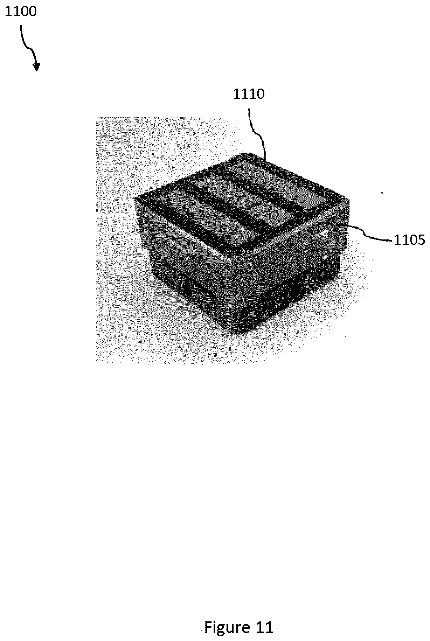

Referring now to Figure 11, this figure shows an example SESF device 1100 having an SESF electrode with spacers to passively control a contact condition of the SESF electrode according to an embodiment. In Figure 11, spacer grid 1110 is attached to SESF electrode 1105 to provide space between a user's skin and the SESF electrode 1105. In embodiments, SESF electrode 1105 is insulated and is an electrostatic friction electrode. A distance contact condition of SESF electrode 1105 can be passively controlled by using a spacer grid 1110 to provide space between a user's skin and the SESF electrode 1105. Thus, in embodiments, a distance contact condition of one or more SESF electrodes can be passively controlled by using one or more spacers configured to provide space between a user's skin and one or more SESF electrodes.

For example, in Figure 11, spacer grid 1110 may have a thickness of 0.5 mm to suspend a user's skin over SESF electrode 1105 and control the distance and/or pressure applied. In other embodiments, one or more spacers may have a thickness of 0.4 mm, 0.6 mm, or another suitable thickness to suspend a user's skin over an SESF electrode. In embodiments, spacers can have different lengths and/or widths to reduce or enlarge a contact area with a user's skin. In embodiments, one or more spacers can be applied to one or more SESF electrodes to control distance or pressure contact conditions of one or more SESF electrodes.

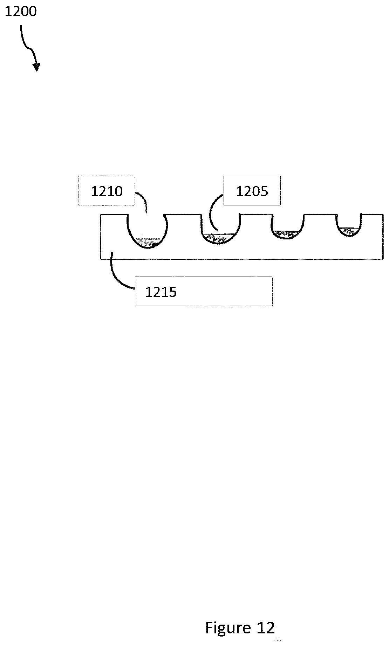

Referring now to Figure 12, this figure shows an example SESF device having SESF electrodes with grooves to passively control a contact condition of the SESF electrodes. In Figure 12, a cross section of band 1215 of SESF device 1200 is shown, which has a plurality of grooves such as groove 1210. As shown in Figure 12, each groove, such as groove 1210, is partially filled with an SESF electrode, such as SESF electrode 1205. In embodiments, SESF electrode 1205 and/or other SESF electrodes in the grooves shown in Figure 12 are insulated SESF electrodes. SESF electrode 1205 and/or other SESF electrodes in the groves shown in Figure 12 can be electrostatic friction electrodes. The spacing distance between the top of an SESF electrode and the top of a groove can passively control a distance contact condition and/or a pressure contact condition applied to the SESF electrode.

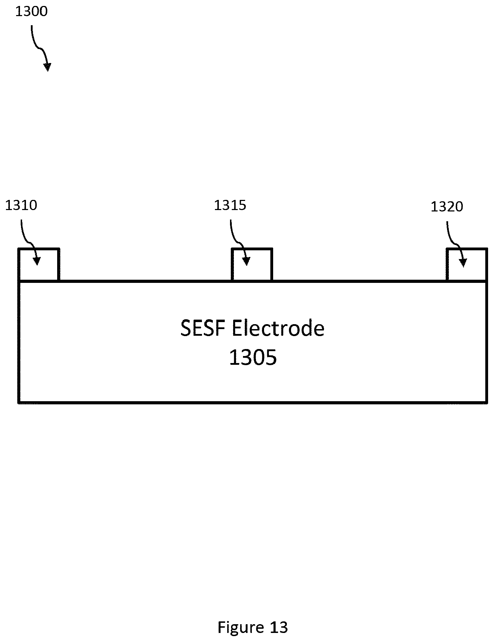

In other embodiments, one or more spaces and/or one or more grooves can be actuated to change a depth of an SESF electrode to actively control a contact condition of the SESF electrode. For example, Figure 13 shows an example SESF device 1300 having an SESF electrode 1305 attached to actuated smart material spacers 1310, 1315, 1325 to actively control a contact condition of the SESF electrode according to an embodiment. In embodiments, SESF electrode 1305 is an insulated SESF electrode and is an electrostatic friction electrode. In Figure 13, smart material spacers 1310, 1315, 1320 actively change thickness to adapt to different types of skin, such as firm skin or fleshy skin, to actively control a contact condition of SESF electrode 1305. In embodiments, one or more actuated spacers and/or one or more actuated grooves are configured to change the depth at which one or more SESF electrodes reside relative to a user's skin. In embodiments, one or more smart material spacers and/or more smart material grooves are thus configured to actively control one or more contact conditions corresponding to one or more SESF electrodes.

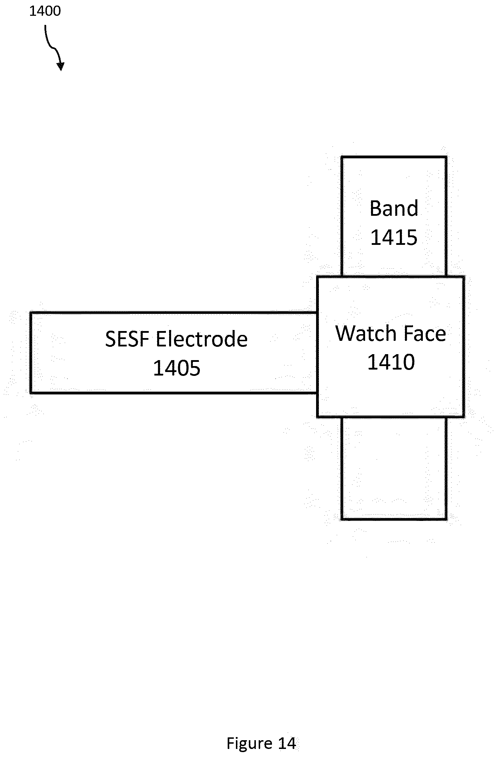

Referring now to Figure 14, this figure shows an example SESF device having a cantilevered SESF electrode to passively control a contact condition of the SESF electrode according to an embodiment. As shown in Figure 14, a watch 1400 has a cantilevered SESF electrode 1405, a watch face 1410, and a band 1415. In this example, cantilevered SESF electrode 1405 is configured to control an amount of applied pressure. In embodiments, cantilevered SESF electrode 1405 is insulated and is a cantilevered electrostatic friction electrode. In embodiments, one or more SESF electrodes are attached to a flexible surface, such as under a flexible flap, that extends from part of an SESF device worn by a user. In this example, such a configuration can extend an area of contact between one or more SESF electrodes to control an amount of pressure applied. In embodiments, an SESF device having one or more cantilevered electrodes has at least one rigid SESF electrode and/or at least one flexible SESF electrode.

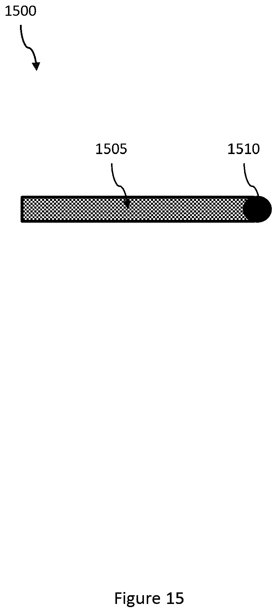

In embodiments, one or more cantilevered electrodes are actuated to control a contact condition, such an amount of pressure applied, of an SESF electrode. For example, Figure 15 shows an example SESF device having a cantilevered SESF electrode to actively control a contact condition of the SESF electrode according to an embodiment. In Figure 15, SESF device 1500 has a cantilevered SESF electrode 1505 attached to an actuated hinge 1510. In this example, the cantilevered SESF electrode 1505 is actuated using the actuated hinge 1510 to control a pressure contact condition of the SESF electrode 1505. In embodiments, cantilevered SESF electrode 1505 is insulated and is a cantilevered electrostatic friction electrode.

In embodiments, one or more contact conditions (e.g., distance, pressure, pressure distribution, etc.) between a user's skin and an SESF electrode is passively or actively controlled. For example, SESF feedback can be felt when a user's skin is a certain distance away from an SESF electrode. Typically this distance is approximately 1 mm from the user's skin; however, greater or lesser distances are within the scope of this disclosure. The SESF feedback felt by a user when a user's skin contacts the SESF electrode may be different than when a user's skin is not touching the ESF electrode. For example, the SESF feedback may be less when the SESF electrode is touching a user's skin than when the SESF electrode is near (e.g., approximately 10 microns) the user's skin but not touching the user's skin.

In one embodiment, with regard to distance, the SESF feedback is strongest when the SESF electrode is very close to but not touching the user's skin. For example, with regard to distance, the SESF feedback may be strongest when the SESF electrode is approximately 10 microns from a user's skin. In some embodiments, the SESF feedback increases as the distance between a user's skin and the SESF electrode decreases from approximately 1 millimeter to almost touching the user's skin. For example, the SESF feedback may increase as the distance between a user's skin and the SESF electrode decreases from 1 millimeter to 10 microns.

With regard to pressure, SESF feedback is strongest when the amount of pressure between the skin and the electrode is minimal in some embodiments. For example, SESF feedback may be weaker when a user applies more pressure with his or her palm against the SESF electrode than when the user is applying less pressure with his or her palm against the SESF electrode. As another example, SESF feedback may be weaker when a wrist band with an SESF electrode is tightened around a user's wrist than when the wrist band with the SESF electrode is loosely placed around the user's wrist.

With regard to pressure distribution, SESF feedback is strongest when the amount of pressure between a user's skin and an SESF electrode is more uniform according to various embodiments. For example, a curved and/or flexible surface that conforms to the shape of the thenar eminence of a user's palm may produce a stronger SESF feedback than a straight surface or another surface that does not conform to the shape of the thenar eminence of the user's palm. As another example, a curved and/or flexible surface that is configured to conform to the shape of a body part of a user (e.g., a user's wrist, a user's palm, etc.) may result in a stronger SESF feedback than a surface that is not configured to conform to the shape of the body part of the user.

Apparatuses, methods, and systems disclosed herein can control one or more contact conditions such as (1) a distance between a user's skin and an SESF electrode; (2) an amount of pressure between a user's skin and an SESF electrode; and/or (3) a pressure distribution between a user's skin and an SESF electrode. In some embodiments, an SESF device passively controls one or more contact conditions (e.g., distance, pressure, pressure distribution, etc.) between a user's skin and an SESF electrode in the SESF device. For example, an SESF device control a distance between a user's skin and an SESF electrode in the SESF device. As another example, an SESF device may control an amount of pressure and a pressure distribution between a user's skin and an SESF electrode in the SESF device. As yet another example, an SESF device may control a distance, an amount of pressure, and a pressure distribution between a user's skin and an SESF electrode in the SESF device.

In other embodiments, an SESF device actively controls one or more contact conditions between a user's skin and an SESF electrode in the SESF device. In yet other embodiments, an SESF device passively controls at least one contact condition between a user's skin and an SESF electrode in the SESF device and actively controls at least one other contact condition between the user's skin and the SESF electrode. In still other embodiments, an SESF device passively controls at least one contact condition between a user's skin and a first SESF electrode in the SESF device and actively controls at least one contact condition between the user's skin and a second ESF electrode in the SESF device.

An SESF device is configured for manual adjustment of a contact condition to increase or decrease SESF feedback in some embodiments. For example, an SESF device may have a screw, knob, or other suitable adjustment that can be turned by a user to manually adjust one or more contact conditions. Such an example may allow a manual adjustment until a user feels that the SESF feedback is optimal for the user.

In other embodiments, an SESF device is configured to automatically adjust a contact condition to increase or decrease SESF feedback provided by an SESF electrode. For example, an SESF can have one or more actuators that alter one or more contact conditions to increase or decrease SESF feedback. In some embodiments, an SESF device automatically adjusts a contact condition to maintain consistent SESF feedback. For example, an SESF can have one or more actuators that alter one or more contact conditions to maintain consistent SESF feedback.

An SESF device may include one or more sensors configured to directly or indirectly monitor one or more contact conditions. For example, a sensor in an SESF device may have one or more sensors that measure a distance between a user's skin and an SESF electrode, measure a force between a surface of an SESF electrode and a user's skin, measure a force exerted by an SESF device on a user's skin (or vice versa), and/or measure a pressure distribution against an SESF electrode. In embodiments, a sensor in an SESF device that is configured to monitor at least one contact condition corresponding to an SESF electrode is a proximity sensor (e.g., a radio frequency (RF) sensor, an optical sensor, etc.), a pressure sensitive surface sensor (e.g., a quantum tunneling composite (QTC) sensor, force sensitive resistor (FSR) sensor, etc.), and/or a contact sensitive surface sensor (e.g., a resistive sensor, a capacitive sensor, an optical sensor, etc.). In other embodiments, an SESF device configured to control a contact condition of an SESF electrode does not require any sensor.

An SESF device can include one or more sensors configured to monitor a deformation of an SESF electrode that is used by the SESF device to control a contact condition corresponding to the SESF electrode. In some embodiments, an SESF device includes one or more sensors configured to monitor a tightness of a band in the SESF device as an indirect measure of a pressure corresponding to an SESF electrode that is used by the SESF device to control a contact condition corresponding to the SESF electrode. As another example, one or more sensors in an SESF device is configured to monitor a physiological condition (e.g., a heartbeat, a breathing pattern, etc.) of a user wearing the SESF device and predict a motion corresponding to an SESF electrode based at least in part on the physiological condition. In this example, the predicted motion can be used to control a contact condition corresponding to the SESF electrode in the SESF device. In embodiments, a contact condition of an SESF electrode can be controlled by the SESF to compensation for the predicted motion, such as a predicted motion of a user's skin in relation to an SESF electrode.

One or more sensors in an SESF device that is configured to monitor a contact condition corresponding to an SESF electrode can be separate from the SESF electrode. In other embodiments, one or more sensors in an SESF device that is configured to monitor a contact condition corresponding to an SESF electrode is integrated into the SESF electrode. In some examples, an external sensor can send sensor data to an SESF device through a cable (such as USB, etc.) or wirelessly (such as Wifi, Bluetooth, etc.). In some examples, a sensor in an SESF device can send sensor data to a processor in the SESF device and/or to an external device (such as another SESF device, a smartphone, etc.).

In embodiments, an SESF device can be any number of devices including, but not limited to a smartwatch, a wristband, an arm bracelet, an ankle bracelet, a headband, an arm cuff, a leg cuff, etc. In some embodiments, an SESF device is a mouse pad or a keyboard having a palm rest. In these embodiments, an SESF electrode and/or a flexible suspension can be included in the palm rest to provide SESF feedback to a user. In addition, in these embodiments, a contact condition of the SESF electrode can be controlled by the flexible suspension to optimize or alert the SESF feedback provided by the SESF electrode.

In embodiments, an SESF device has at least one inflatable pocket configured to move an SESF electrode closer to or farther away from a user's skin. In some embodiments, an SESF device has an active mechanism, such as a DC motor, that is configured to move an SESF electrode closer to or farther away from a user's skin. In embodiments, an SESF device has a manual mechanism, such as a screw, that is configured to move an SESF electrode closer to or farther away from a user's skin.

An SESF device can include a squeezing band that is configured to be actuated to adjust a tightness of the squeezing band. In such an example, a suitable squeezing band could comprise a DC motor, an inflatable pocket, a shape memory polymer, and/or a shape memory actuation (SMA) actuator. In some embodiments, the tightness of the squeezing band can be adjusted to affect a strength of SESF feedback of an SESF electrode.

In some embodiments where a mechanism controls a distance between a user's skin and an SESF electrode, the distance is varied at a particular frequency. For example, the distance may be varied at a particular frequency to create a specific pattern of variations in the SESF feedback provided by an SESF electrode. In some embodiments, an SESF device has a vibration actuator attached to an SESF electrode. For example, a vibration actuator may be attached under an SESF electrode. In embodiments, a vibration actuator - such as a piezoelectric actuator, eccentric rotating mass (ERM) motor, or a linear resonant actuator (LRA) - is configured to provide a variation in SESF feedback provided by an SESF electrode attached to the vibration actuator. For example, the vibration actuator can be configured to increase a strength of SESF feedback provided by an SESF electrode.

In one embodiment, an SESF device has at least a flexible band, a motor, and an SESF electrode. In this embodiment, the SESF device is worn by a user, such as on a user's wrist, and the SESF electrode is facing the user's wrist when the SESF device is worn. In this example, the motor can tighten or loosen the band on the user's wrist. The band and motor can thus be used to control an amount of pressure that is applied to the SESF electrode by the user's wrist by adjusting the tightness or looseness of the band.

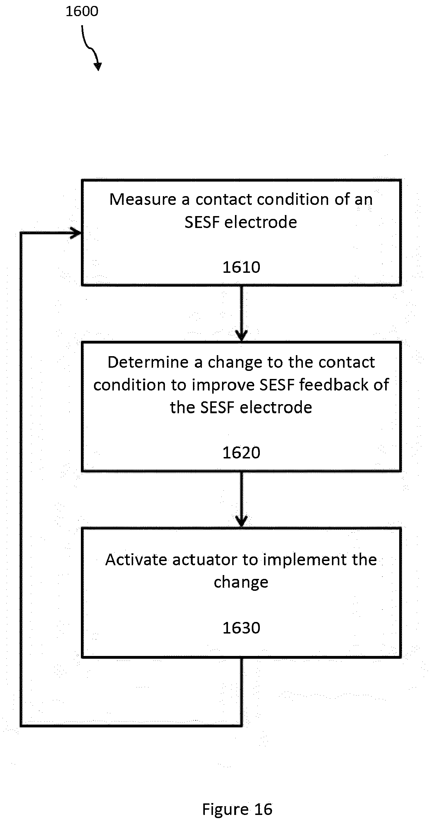

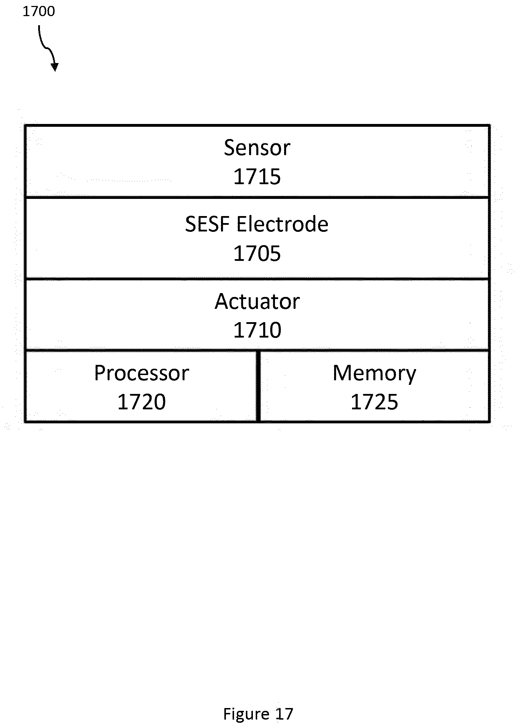

Referring now to Figure 16, this figure shows an example method of actively controlling a contact condition of an SESF electrode according to an embodiment. Reference will be made to SESF device 1700 of Figure 17; however, any suitable SESF device according to this disclosure may be employed that actively controls at least one contact condition of an SESF electrode.

The method 1600 begins at block 1610 when a contact condition of an SESF electrode 1705 is measured by sensor 1715. In this example, the sensor 1715 is configured to measure a distance contact condition between SESF electrode 1705 an a user's skin when a user wears SESF device 1700. In embodiments, one or more contact conditions (e.g., distance, pressure, pressure distribution, etc.) of one or more SESF electrodes is measured by one or more sensors. For example, in Figure 17, sensor 1715 is a proximity sensor, such as a radio frequency sensor or an optical sensor. In some other examples, one or more sensors configured to measure a contact condition of an SESF electrode may be a proximity sensor (e.g., a radio frequency (RF) sensor, an optical sensor, etc.), a pressure sensitive surface sensor (e.g., a quantum tunneling composite (QTC) sensor, force sensitive resistor (FSR) sensor, etc.), and/or a contact sensitive surface sensor (e.g., a resistive sensor, a capacitive sensor, an optical sensor, etc.). In embodiments, an SESF electrode discussed herein with respect to the method shown in Figure 16 and/or the SESF electrode 1705 shown in Figure 17 are insulated SESF electrodes.

At block 1620, the SESF device 1700 determines a change to the contact condition to improve SESF feedback of the SESF electrode 1705. For example, if processor 1720 in SESF device 1700, which is in communication with memory 1725, determines that SESF electrode 1705 is too far from a user's skin based on the measurement taken by sensor 1715, then processor 1720 determines that actuator 1710 needs to move the SESF electrode 1705 closer to the user's skin. In one embodiment, if SESF electrode 1705 is greater than 1 millimeter from the user's skin, then processor 1720 determines that actuator 1710 needs to move the SESF electrode 1705 closer to the user's skin. In this example, processor 1720 generates an actuator signal configured to cause actuator 1710 to move SESF electrode 1705 closer to the user's skin. In one embodiment, processor 1720 generates an actuator signal configured to cause actuator 1710 to move SESF electrode 1705 to approximately 10 microns from the user's skin. In another embodiment, processor 1720 generates an actuator signal configured to cause actuator 1710 to move SESF electrode 1705 to approximately 1 millimeter from the user's skin. In yet other embodiments, processor 1720 generates an actuator signal configured to cause actuator 1710 to move SESF electrode 1705 to between 1 millimeter and 10 microns from the user's skin.

As another example, if processor 1720 in SESF device 1700 determines that SESF electrode 1705 is too close to a user's skin based on the measurement taken by sensor 1715, then processor 1720 determines that actuator 1710 needs to move the SESF electrode 1705 further from the user's skin. In one embodiment, if SESF electrode 1705 is less than 10 microns from the user's skin, then processor 1720 determines that actuator 1710 needs to move the SESF electrode 1705 further from the user's skin. In this example, processor 1720 generates an actuator signal configured to cause actuator 1710 to move SESF electrode 1705 further away from the user's skin. In one embodiment, processor 1720 generates an actuator signal configured to cause actuator 1710 to move SESF electrode 1705 to approximately 10 microns from the user's skin. In another embodiment, processor 1720 generates an actuator signal configured to cause actuator 1710 to move SESF electrode 1705 to approximately 1 millimeter from the user's skin. In yet other embodiments, processor 1720 generates an actuator signal configured to cause actuator 1710 to move SESF electrode 1705 to between 1 millimeter and 10 microns from the user's skin.

In various embodiments, a change can be determined in different ways. In embodiments, a change is determined to maintain a consistent distance, pressure, and/or pressure distribution between an SESF electrode and a user's skin. For example, using a measured distance of an SESF electrode from a user's skin, a change can be determined such that the distance between the SESF electrode and the user's skin will be approximately 10 microns after the change is made. In other examples, a change may be determined such that the distance between the SESF electrode and the user's skin will be between 1 millimeter and 10 microns.

At block 1630, the SESF device 1700 activates actuator 1710 to implement the determined change. For example, processor 1720 sends the generated actuator signal configured to cause the SESF electrode 1705 to move closer to or farther away from the SESF electrode to actuator 1710. In response, actuator 1710 moves at least part of SESF electrode 1705 closer to or further away from the user's skin. In other embodiments, actuator 1710 is attached to a flexible material, such as a smart material, and the flexible material is attached to SESF electrode 1705. In these embodiments, actuator 1710 is configured to alter the flexible material such that the flexible material alters a contact condition of SESF electrode 1705. For example, actuator 1710 may cause the flexible material to contract to move SESF electrode 1705 further away from a user. In embodiments, after block 1630, the method 1600 returns to block 1610.

While some examples of devices, systems, and methods herein are described in terms of software executing on various machines, the methods and systems may also be implemented as specifically-configured hardware, such as field-programmable gate array (FPGA) specifically to execute the various methods. For example, examples can be implemented in digital electronic circuitry, or in computer hardware, firmware, software, or in a combination thereof. In one example, a device may include a processor or processors. The processor comprises a computer-readable medium, such as a random access memory (RAM) coupled to the processor. The processor executes computer-executable program instructions stored in memory, such as executing one or more computer programs for editing an image. Such processors may comprise a microprocessor, a digital signal processor (DSP), an application-specific integrated circuit (ASIC), field programmable gate arrays (FPGAs), and state machines. Such processors may further comprise programmable electronic devices such as PLCs, programmable interrupt controllers (PICs), programmable logic devices (PLDs), programmable read-only memories (PROMs), electronically programmable read-only memories (EPROMs or EEPROMs), or other similar devices.

Such processors may comprise, or may be in communication with, media, for example computer-readable storage media, that may store instructions that, when executed by the processor, can cause the processor to perform the steps described herein as carried out, or assisted, by a processor. Examples of computer-readable media may include, but are not limited to, an electronic, optical, magnetic, or other storage device capable of providing a processor, such as the processor in a web server, with computer-readable instructions. Other examples of media comprise, but are not limited to, a floppy disk, CD-ROM, magnetic disk, memory chip, ROM, RAM, ASIC, configured processor, all optical media, all magnetic tape or other magnetic media, or any other medium from which a computer processor can read. The processor, and the processing, described may be in one or more structures, and may be dispersed through one or more structures. The processor may comprise code for carrying out one or more of the methods (or parts of methods) described herein.

The foregoing description of some examples has been presented only for the purpose of illustration and description and is not intended to be exhaustive or to limit the disclosure to the precise forms disclosed. Numerous modifications and adaptations thereof will be apparent to those skilled in the art without departing from the spirit and scope of the disclosure.

Reference herein to an example or implementation means that a particular feature, structure, operation, or other characteristic described in connection with the example may be included in at least one implementation of the disclosure. The disclosure is not restricted to the particular examples or implementations described as such. The appearance of the phrases "in one example," "in an example," "in one implementation," or "in an implementation," or variations of the same in various places in the specification does not necessarily refer to the same example or implementation. Any particular feature, structure, operation, or other characteristic described in this specification in relation to one example or implementation may be combined with other features, structures, operations, or other characteristics described in respect of any other example or implementation.

## Claims

1. A static electrostatic force output device (100, 200, 300, 400, 500, 600, 700, 800, 900, 1000, 1100, 1200, 1300, 1400, 1500) comprising:
an insulated static electrostatic force electrode (105, 205, 305, 310, 315, 320, 325, 330, 335, 405, 505, 605, 735, 805, 905, 1005, 1105, 1205, 1305, 1405, 1505) configured to provide static electrostatic force feedback to a user and comprising a first surface configured to face toward the user's skin and a second surface opposite the first surface; and
a flexible suspension (110, 210, 215, 220, 340, 345, 350, 355, 360, 365, 370, 410, 510, 515, 520, 610, 615, 10, 715, 720, 725, 730, 810, 1415) attached to the second surface of the insulated static electrostatic force electrode and configured to at least partially move in relation to the insulated static electrostatic force electrode to control a contact condition corresponding to the insulated static electrostatic force electrode.

2. The static electrostatic force output device (100, 200, 300, 400, 500, 600, 700, 800, 900, 1000, 1100, 1200, 1300, 1400, 1500) of claim 1, wherein the flexible suspension comprises any one or more of:
A) a layer of rubber attached to the second surface of the insulated static electrostatic force electrode (105, 205, 305, 310, 315, 320, 325, 330, 335, 405, 505, 605, 735, 805, 905, 1005, 1105, 1205, 1305, 1405, 1505);
B) a layer of foam attached to the second surface of the insulated static electrostatic force electrode;
C) a smart material (410) attached to the second surface of the insulated static electrostatic force electrode, and wherein the insulated static electrostatic force electrode is a rigid static electrostatic force electrode;
D) a smart material (410) attached to the second surface of the insulated static electrostatic force electrode and a plurality of flexible posts (510, 515) attached to the smart material, and wherein the insulated static electrostatic force electrode is a flexible static electrostatic force electrode.

3. The static electrostatic force output device (100, 200, 300, 400, 500, 600, 700, 800, 900, 1000, 1100, 1200, 1300, 1400, 1500) of claims 1 or 2, wherein the insulated static electrostatic force electrode (105, 205, 305, 310, 315, 320, 325, 330, 335, 405, 505, 605, 735, 805, 905, 1005, 1105, 1205, 1305, 1405, 1505) comprises any one or more of:
A) a static electrostatic force electrode array (305, 310, 315, 320, 325, 330, 335);
B) a plurality of static electrostatic force electrodes and the flexible suspension comprises a plurality of springs (340, 345, 350, 355, 360, 365, 370) corresponding to the first plurality of static electrostatic force electrodes.

4. The static electrostatic force output device (100, 200, 300, 400, 500, 600, 700, 800, 900, 1000, 1100, 1200, 1300, 1400, 1500) of any of claims 1-3, wherein the insulated static electrostatic force output device does not comprise any one or more of:
A) an actuator (1710) that controls the contact condition corresponding to the insulated static electrostatic force electrode (105, 205, 305, 310, 315, 320, 325, 330, 335, 405, 505, 605, 735, 805, 905, 1005, 1105, 1205, 1305, 1405, 1505);
B) a sensor (1715) that measures the contact condition corresponding to the insulated static electrostatic force electrode.

5. The static electrostatic force output device (100, 200, 300, 400, 500, 600, 700, 800, 900, 1000, 1100, 1200, 1300, 1400, 1500) of any preceding claim, further comprising:
a flexible band attached to the insulated static electrostatic force electrode; and
a motor attached to the flexible band, the motor configured to control a tightness of the flexible band.

6. The static electrostatic force output device (100, 200, 300, 400, 500, 600, 700, 800, 900, 1000, 1100, 1200, 1300, 1400, 1500) of any preceding claim, wherein the flexible suspension comprises any one or more of:
A) a flexible flap that extends from a part of the insulated static electrostatic force output device worn by the user, and wherein the insulated static electrostatic force electrode (1405) is attached to the flexible flap;
B) a band (1415) and the insulated static electrostatic force electrode (1405) is cantilevered with respect to the band.

7. The static electrostatic force output device (100, 200, 300, 400, 500, 600, 700, 800, 900, 1000, 1100, 1200, 1300, 1400, 1500) of any preceding claim, wherein the insulated static electrostatic force electrode comprises any one or more of:
A) a plurality of curls;
B) at least one of a first plurality of spacers or a second plurality of grooves;
C) a curved shape conforming to the user's wrist.

8. The static electrostatic force output device (100, 200, 300, 400, 500, 600, 700, 800, 900, 1000, 1100, 1200, 1300, 1400, 1500) of any preceding claim, wherein the flexible suspension comprises a smart material and the device further comprises an actuator (1710) integrated into or attached to the smart material.

9. A method comprising:
measuring (1610), by a sensor (1715), a contact condition corresponding to an insulated static electrostatic force electrode (1705);
determining (1620), by a processor (1720), a change to the contact condition to improve static electrostatic force feedback provided by the insulated static electrostatic force electrode to a user;
generating, by the processor, an actuator signal configured to cause an actuator to implement the change; and
outputting the actuator signal to the actuator (1710) to implement the change.

10. A non-transitory computer-readable medium (1725) comprising one or more software applications configured to be executed by a processor (1720), the one or more software applications configured to:
receive a contact condition corresponding to an insulated static electrostatic force electrode (1705) from a sensor (1715);
determine a change to the contact condition to improve static electrostatic force provided by the insulated static electrostatic force electrode to a user;
generate an actuator signal configured to cause an actuator to implement the change; and
output the actuator signal to the actuator (1710) to implement the change.

11. The method of claim 9 or the non-transitory computer-readable medium of claim 10, wherein the sensor (1715) comprises at least one of a proximity sensor, a pressure sensitive surface sensor, or a contact sensitive surface sensor.

12. The method of claims 9 or 11 or the non-transitory computer-readable medium of any of claims 10-11, wherein the actuator comprises a smart material and the actuator (1710) implements the change by altering the smart material to move the insulated static electrostatic force electrode (105, 205, 305, 310, 315, 320, 325, 330, 335, 405, 505, 605, 735, 805, 905, 1005, 1105, 1205, 1305, 1405, 1505).

13. The method of any of claims 9, 11-12 or the non-transitory computer-readable medium of any of claims 10-12, wherein the contact condition comprises at least one of a distance between the user's skin and the insulated static electrostatic force electrode (105, 205, 305, 310, 315, 320, 325, 330, 335, 405, 505, 605, 735, 805, 905, 1005, 1105, 1205, 1305, 1405, 1505), an amount of pressure between the user's skin and the insulated static electrostatic force electrode, or a pressure distribution between the user's skin and the insulated static electrostatic force electrode.

14. The method of any of claims 9, 11-13 or the non-transitory computer-readable medium of any of claims 10-13, wherein the change is configured to cause the insulated static electrostatic force electrode (105, 205, 305, 310, 315, 320, 325, 330, 335, 405, 505, 605, 735, 805, 905, 1005, 1105, 1205, 1305, 1405, 1505) to provide any one or more of:
A) consistent static electrostatic force feedback to the user;
B) increased static electrostatic force feedback to the user.

15. The method of any of claims 9, 11-14 or the non-transitory computer-readable medium of any of claims 10-14, wherein the actuator signal is configured to cause the actuator (1710) to tilt the insulated static electrostatic force electrode.
